(19) Europäisches Patentamt
European Patent Office
Office européen des brevets

(11) **EP 2 818 879 B1**

(12) **FASCICULE DE BREVET EUROPEEN**

(45) Date de publication et mention
de la délivrance du brevet:
**03.04.2019 Bulletin 2019/14**

(51) Int Cl.:
***G01R 27/20*** *(2006.01)*

(21) Numéro de dépôt: **14173629.8**

(22) Date de dépôt: **24.06.2014**

(54) **Dispositif d'estimation de l'impédance d'une liaison électrique de terre, procédé d'estimation et système d'alimentation électrique associés**

Vorrichtung zum Schätzen der Impedanz einer elektrischen Erdverbindung, entsprechendes Schätzverfahren und entsprechendes Stromversorgungssystem

Device for estimating the impedance of an electrical ground connection, related estimation method and power supply system

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.06.2013 FR 1356155**

(43) Date de publication de la demande:
**31.12.2014 Bulletin 2015/01**

(73) Titulaire: **Schneider Electric Industries SAS**
**92500 Rueil-Malmaison (FR)**

(72) Inventeurs:
• **Vincent, François**
**38050 Grenoble Cedex 9 (FR)**
• **Tian, Simon**
**38050 Grenoble Cedex 9 (FR)**

(74) Mandataire: **Lavoix**
**62, rue de Bonnel**
**69448 Lyon Cedex 03 (FR)**

(56) Documents cités:
EP-A1- 2 551 981    JP-A- 2009 210 438
JP-A- 2009 238 573    JP-A- 2010 205 570

**Description**

La présente invention concerne un dispositif d'estimation de l'impédance d'une liaison électrique de terre, la liaison de terre étant reliée à la terre d'un réseau électrique alternatif, le réseau électrique alternatif comprenant une phase reliée à un conducteur électrique de phase et un neutre relié à un conducteur électrique de neutre, le dispositif étant destiné à être raccordé au conducteur de phase, au conducteur de neutre et à la liaison de terre.

L'invention concerne également un système d'alimentation d'une installation électrique, le système étant relié à un réseau électrique alternatif comprenant une phase reliée à un conducteur électrique de phase, un neutre relié à un conducteur électrique de neutre et une terre reliée à une liaison électrique de terre.

L'invention concerne également un procédé d'estimation de l'impédance d'une liaison électrique de terre.

On connaît du document EP 2 551 981 A1 un dispositif d'estimation de l'impédance d'un conducteur de terre. Le dispositif comprend un générateur de tension et un capteur de courant reliés en série entre le conducteur de phase et le conducteur de terre. L'impédance du conducteur de terre est calculée à partir de la valeur de la tension imposée par le générateur, et de la valeur du courant circulant à travers le conducteur de terre et le conducteur de phase, mesurée par le capteur de courant.

Toutefois, un tel dispositif ne permet pas d'estimer l'impédance du conducteur de terre de plusieurs installations électriques raccordées à un même réseau électrique, telles que par exemple des bornes de charge d'une station de charge de véhicule électrique. En effet, ce type de dispositif, lorsqu'il est raccordé à plusieurs installations électriques d'un même réseau électrique, génère des courants de fuite additionnels importants, qui empêchent la mesure précise de l'impédance du conducteur de terre.

Un but de l'invention est donc de proposer un dispositif d'estimation de l'impédance d'une liaison électrique de terre pouvant être installé sur plusieurs installations électriques raccordées à un même réseau électrique.

A cet effet, l'invention a pour objet un dispositif d'estimation d'une liaison électrique de terre tel que revendiqué à la revendication 1.

Suivant d'autres aspects avantageux de l'invention, le dispositif d'estimation comprend les caractéristiques de l'une quelconque des revendications 2 à 4.

L'invention a également pour objet un système d'alimentation électrique tel que revendiqué à la revendication 5.

Suivant d'autres aspects avantageux de l'invention, le système d'alimentation électrique est tel que revendiqué à l'une quelconque des revendications 6 et 7.

L'invention a également pour objet un procédé d'estimation de l'impédance d'une liaison électrique de terre tel que revendiqué à la revendication 8.

Suivant d'autres aspects avantageux de l'invention, le procédé d'estimation de l'impédance d'une liaison électrique de terre comprend les caractéristiques de l'une quelconque des revendications 9 et 10.

Ces caractéristiques et avantages de l'invention apparaîtront à la lecture de la description qui va suivre, donnée uniquement à titre d'exemple non limitatif, et faite en référence aux dessins annexés, sur lesquels :

- la figure 1 est une modélisation schématique d'une installation électrique connectée à un réseau de distribution électrique ;
- la figure 2 est une représentation schématique d'un dispositif d'estimation selon l'invention, relié au système d'alimentation selon l'invention ;
- la figure 3 est une vue analogue à celle de la figure 2, selon une variante de réalisation de l'invention ;
- la figure 4 est un organigramme d'un procédé d'estimation de l'impédance d'une liaison électrique de terre.

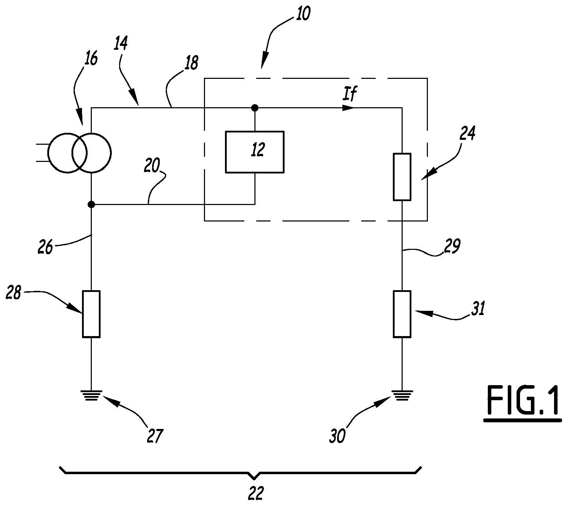

Sur la figure 1, un système d'alimentation électrique 10 comprenant une installation électrique 12 est relié à un réseau électrique alternatif 14. Le réseau électrique 14 est alimenté par un transformateur électrique 16. Le réseau électrique 14 comprend un conducteur électrique de phase 18 relié à la phase du transformateur 16, un conducteur électrique de neutre 20 relié au neutre du transformateur 16 et une liaison électrique de terre 22 reliée à la terre.

Le système d'alimentation 10 est propre à alimenter électriquement l'installation électrique 12. Lorsque l'installation électrique 12 est raccordée au réseau 14, un courant de fuite If vers la terre peut apparaître. On a représenté sur la figure 1 l'impédance de fuite 24 à travers laquelle s'écoule le courant de fuite If. L'impédance de fuite 24 présente une valeur Zf.

L'installation électrique 12 est, par exemple, un chargeur de batterie d'un véhicule automobile électrique, connecté au réseau électrique 14 par l'intermédiaire d'une borne de charge (non représentée).

En variante, l'installation électrique 12 est un bâtiment, par exemple une habitation, connecté au réseau électrique 14.

Le réseau électrique 14 est, par exemple, un réseau alternatif monophasé, comprenant une phase et un neutre. En variante, le réseau électrique 14 est un réseau électrique triphasé.

Le transformateur électrique 16 forme une source de tension pour le système d'alimentation 10. Le transformateur électrique 16 est relié à la terre par l'intermédiaire d'un premier conducteur de terre 26 et d'une première prise de terre 27. Le premier conducteur de terre 26 et la première prise de terre 27 présentent une première impédance de terre 28 ayant une valeur Za.

Le transformateur électrique 16 est relié à l'installation électrique 12 par l'intermédiaire du conducteur de phase 18 et du conducteur de neutre 20. La carcasse de l'installation électrique 12 est reliée à la terre par l'intermédiaire d'un second conducteur de terre 29 et d'une seconde prise de terre 30. Le second conducteur de terre 29 et la seconde prise de terre 30 présentent une seconde impédance de terre 31 ayant une valeur Zb.

Ainsi, dans l'exemple de réalisation décrit, la liaison électrique de terre 22 est formée par le premier conducteur de terre 26 et la première prise de terre 27 reliant le transformateur électrique 16 à la terre, et par le second conducteur de terre 29 et la seconde prise de terre 30 reliant la carcasse de l'installation électrique 12 à la terre. La liaison de terre 22 présente une impédance ayant une valeur Zt égale à la somme des valeurs Za, Zb des première et seconde impédances 28, 31.

Suivant les figures 1 à 3, le système d'alimentation 10 est raccordé à la terre suivant le régime « TT ». Plus précisément, le neutre du transformateur 16 et la carcasse de l'installation électrique 12 sont chacun reliés à la terre par l'intermédiaire des première et seconde prises de terre distinctes 27, 30.

D'autres types de raccordement à la terre du système d'alimentation 10 sont possibles.

Suivant le régime « TN » (non représenté), la carcasse de l'installation électrique 12 n'a pas de terre locale et est reliée au conducteur de neutre. Le conducteur de neutre est relié à la terre locale du transformateur.

Suivant le régime « IT » (non représenté), le neutre du transformateur électrique 16 est isolé électriquement par rapport à la terre, et la carcasse de l'installation électrique 12 est reliée à la terre par l'intermédiaire d'une prise de terre locale.

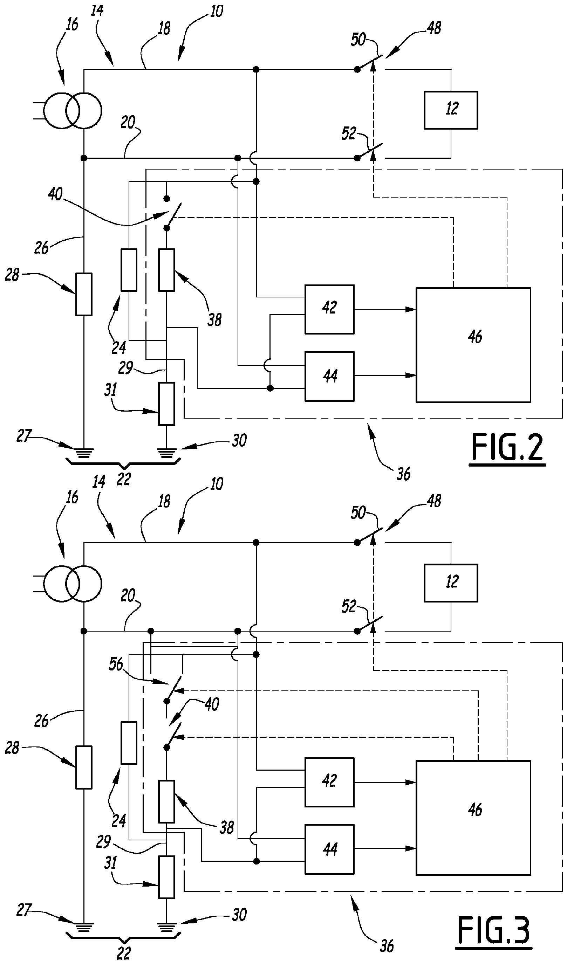

Comme représenté sur les figures 2 et 3, le système d'alimentation 10 comprend en outre un dispositif d'estimation 36 de la valeur Zt de l'impédance de la liaison de terre 22. Le dispositif d'estimation 36 est représenté en pointillés sur les figures 2 et 3.

Suivant les figures 2 et 3, le dispositif 36 d'estimation comprend un composant électrique 38 relié au second conducteur de terre 29 et propre à être relié au conducteur de phase 18. Le dispositif d'estimation 36 comprend en outre un commutateur 40 propre à isoler ou relier électriquement le composant électrique 38 au conducteur de phase 18.

Le dispositif d'estimation 36 est propre à estimer la valeur Zt de l'impédance de la liaison de terre 22, c'est-à-dire qu'il est propre à estimer la somme des valeurs Za, Zb des première et seconde impédances 28, 31.

Le dispositif d'estimation 36 est raccordé au conducteur de phase 18, au conducteur de neutre 20 et au second conducteur de terre 29.

Le composant électrique 38 présente une impédance de valeur prédéterminée Zc. Le composant électrique 38 est par exemple un composant présentant une impédance résistive, tel qu'une résistance.

Le commutateur 40 est connecté en série avec le composant électrique 38 entre le conducteur de phase 18 et la seconde impédance de terre 31 du second conducteur de terre 29.

Le commutateur 40 est par exemple un relais électromagnétique bistable. En variante, le commutateur 40 est un interrupteur électronique.

Le commutateur 40 est mobile entre un état ouvert et un état fermé. Dans l'état ouvert, le commutateur 40 isole électriquement le composant électrique 38 du conducteur de phase 18. Dans l'état fermé, le commutateur 40 relie électriquement le composant électrique 38 au conducteur de phase 18.

Comme représenté sur les figures 2 et 3, le dispositif d'estimation 36 comprend en outre un premier capteur 42, un deuxième capteur 44, et un organe de calcul 46.

Le premier capteur 42 est propre à mesurer une première valeur $Vpt_0$ d'une première grandeur électrique Vpt, par exemple une tension, entre le conducteur de phase 18 et le second conducteur de terre 29 lorsque le commutateur 40 est dans l'état ouvert, et une deuxième valeur $Vpt_1$ de la première grandeur électrique Vpt lorsque le commutateur est dans l'état fermé.

Le deuxième capteur 44 est propre à mesurer une première valeur $Vnt_0$ d'une deuxième grandeur électrique Vnt, par exemple une tension électrique, entre le conducteur de neutre 20 et le second conducteur de terre 29 lorsque le commutateur 40 est dans l'état ouvert, et une deuxième valeur $Vnt_1$ de la deuxième grandeur électrique Vnt lorsque le commutateur 40 est dans l'état fermé.

Comme il sera décrit par la suite, l'organe de calcul 46 est propre à calculer la valeur Zt de l'impédance de la liaison de terre 22 à partir de la valeur prédéterminée Zc de l'impédance du composant électrique 38 et des valeurs $Vpt_0$, $Vpt_1$, $Vnt_0$, $Vnt_1$ des tensions mesurées par les premier et deuxième capteurs 42, 44 dans les états ouvert et fermé du commutateur 40.

L'organe de calcul 46 est par exemple formé par un microprocesseur.

Le système d'alimentation 10 comprend en outre un organe de coupure 48.

L'organe de coupure 48 est relié électriquement au conducteur de phase 18 et au conducteur de neutre 20 entre le transformateur électrique 16 et l'installation électrique 12.

L'organe de coupure 48 est par exemple formé par un premier interrupteur 50 disposé sur le conducteur de phase 18 entre le transformateur 16 et l'installation électrique 12, et par un second interrupteur 52 disposé sur le conducteur de neutre 20 entre le transformateur 16 et l'installation électrique 12.

Les premier et second interrupteurs 50, 52 sont mobiles entre une position ouverte dans laquelle l'installation électrique 12 est isolée électriquement du transformateur 16, et une position fermée dans laquelle l'installation électrique 12 est reliée électriquement au transformateur 16 par l'intermédiaire des conducteurs de phase 18 et de neutre 20.

Lorsque la valeur Zt de l'impédance de terre calculée est inférieure à une valeur seuil $Zt_{seuil}$, le système d'alimentation 10 est autorisé à fonctionner, et l'installation électrique 12 est mise sous tension. Les premier et second interrupteurs 50, 52 sont alors en position fermée.

Lorsque la valeur Zt de l'impédance de la liaison de terre 22 calculée est supérieure à une valeur seuil $Zt_{seuil}$, le fonctionnement du système d'alimentation 10 varie selon la nature de l'installation électrique 12 à laquelle est raccordée le dispositif d'estimation 36.

Si l'installation électrique 12 est, par exemple, une borne de charge d'un véhicule électrique, les premier et second interrupteurs 50, 52 sont commandés en position ouverte par l'organe de calcul 46, de sorte que la borne de charge n'est plus alimentée.

Si l'installation électrique 12 est, par exemple, un bâtiment, tel qu'une habitation, une alarme de sécurité est émise.

La valeur seuil $Zt_{seuil}$ de l'impédance de la liaison de terre 22 est comprise entre 10 ohms et 500 ohms, et en particulier sensiblement égale à 100 ohms.

Selon une variante de réalisation représentée sur la figure 3, le dispositif d'estimation 36 comprend des moyens 42, 44, 46, 56 de détection du conducteur de phase 18 parmi le conducteur de phase 18 et le conducteur de neutre 20.

Les moyens de détection 42, 44, 46, 56 comprennent, par exemple, un relais 56 à deux états, les premier et deuxième capteurs 42, 44 et l'organe de calcul 56.

Le relais 56 est mobile entre deux états. Dans un premier état, le relais 56 relie le conducteur de phase 18 au relais 40. Dans un deuxième état, le relais 56 relie le conducteur de neutre 20 au relais 40.

En variante (non représentée), le relais 56 et le commutateur 40 sont formés par un unique relais à trois états. Dans un premier état, le relais relie le conducteur de phase 18 au composant électrique 38. Dans un deuxième état, le relais relie le conducteur de neutre 20 au composant électrique 38. Dans un troisième état, le composant électrique 38 est isolé des conducteurs de phase 18 et de neutre 20.

En variante (non représentée), le relais 56 et le commutateur 40 sont formés par deux relais à deux états connectés en parallèle. Dans un premier état, les deux relais relient respectivement le conducteur de phase 18 et le conducteur de neutre 20 au composant électrique 38. Dans un deuxième état, les deux relais sont ouverts et le composant électrique 38 est isolé du conducteur de phase 18 et du conducteur de neutre 20.

Le premier capteur 42 est propre à mesurer la tension électrique entre le conducteur de phase 18 et le second conducteur de terre 29, et le deuxième capteur 44 est propre à mesurer la tension électrique entre le conducteur de neutre 20 et le second conducteur de terre 29.

En fonction des valeurs des tensions mesurées par les premier et deuxième capteurs 42, 44, l'organe de calcul 46 est propre à reconnaître le conducteur de phase parmi les deux conducteurs correspondant au conducteur de phase 18 et au conducteur de neutre 20.

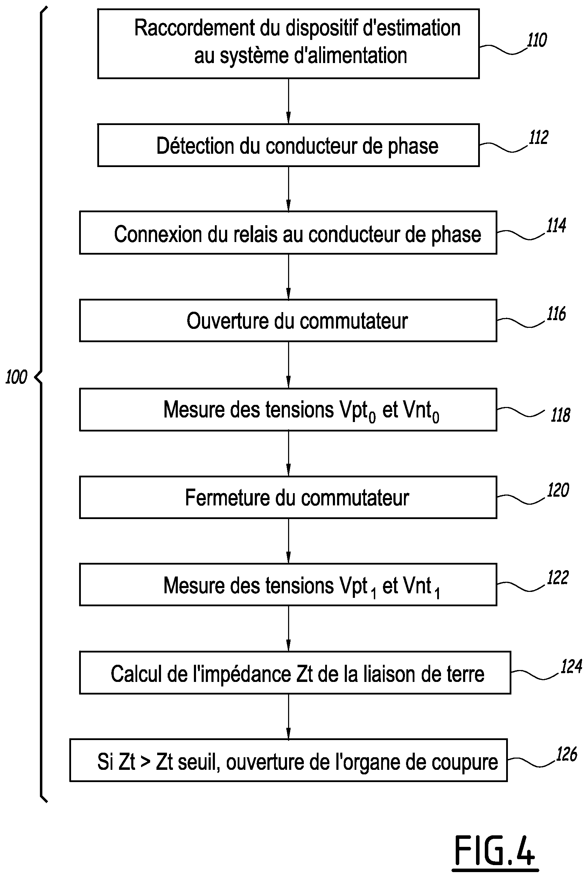

Le fonctionnement du dispositif d'estimation 36 va désormais être expliqué à l'aide de la figure 4. La figure 4 représente un organigramme des étapes d'un procédé 100 d'estimation de l'impédance Zt de la liaison de terre 22, mis en oeuvre par le dispositif d'estimation 36 tel que décrit ci-dessus.

Sur la figure 4, lors de la première étape 110, le dispositif d'estimation 36 selon l'invention est raccordé au conducteur de phase 18, au conducteur de neutre 20 et au second conducteur de terre 29 du système d'alimentation 10. Le système d'alimentation 10 est relié, d'une part, au réseau électrique 14 par l'intermédiaire du transformateur 16, et d'autre part, à une installation électrique 12, par exemple à un chargeur de batterie de véhicule électrique ou un bâtiment, par l'intermédiaire du conducteur de phase 18 et du conducteur de neutre 20. Les premier et second interrupteurs 50 et 52 sont en position fermée.

Lors de l'étape 112, les moyens de détection 42, 44, 46, 56 détectent le conducteur de phase 18 parmi les deux conducteurs correspondant au conducteur de phase 18 et au conducteur de neutre 20. Plus précisément, le premier capteur 42 mesure par exemple la tension électrique entre le conducteur de phase 18 et le second conducteur de terre 29. Si la tension mesurée est proche de 230 V, alors il s'agit de la tension entre le conducteur de phase 18 et le second conducteur de terre 29, et le conducteur de phase 18 est alors identifié. En variante, le deuxième capteur 44 mesure la tension électrique entre le conducteur de neutre 20 et le second conducteur de terre 29. Si la tension mesurée est proche de 0 V, alors il s'agit de la tension entre le conducteur de neutre 20 et le second conducteur de terre 29, et le conducteur de neutre 20 est alors identifié.

Une fois le conducteur de phase 18 détecté, le relais 56 est positionné dans le premier état lors de l'étape 114, de façon à relier électriquement le composant électrique 38 au conducteur de phase 18.

Lors de l'étape 116, le commutateur 40 est commandé pour être positionné dans l'état ouvert, c'est-à-dire que le composant électrique 38 est isolé électriquement du conducteur de phase 18.

Ensuite, lors de l'étape 118, le premier capteur 42 mesure la tension $Vpt_0$ entre le conducteur de phase 18 et le second conducteur de terre 29, et le deuxième capteur 44 mesure la tension $Vnt_0$ entre le conducteur de neutre 20 et le second conducteur de terre 29.

Lors de l'étape suivante 120, le commutateur 40 est commandé pour être positionné dans l'état fermé, dans lequel le composant électrique 38 est relié électriquement au conducteur de phase 18.

Suite à l'étape 120, le premier capteur 42 mesure la tension $Vpt_1$ entre le conducteur de phase 18 et le second conducteur de terre 29, et le deuxième capteur 44 mesure la tension $Vnt_1$ entre le conducteur de neutre 20 et le second conducteur de terre 29, lors de l'étape 122.

Ensuite, lors de l'étape 124, l'organe de calcul 46 calcule la valeur $Zt$ de l'impédance de la liaison de terre 22 à partir de la valeur prédéterminée $Zc$ de l'impédance du composant électrique 38 et des valeurs $Vpt_0$, $Vnt_0$, $Vpt_1$, $Vnt_1$ des tensions mesurées.

Plus précisément, la loi d'Ohm est appliquée dans le système d'alimentation 10 lorsque le commutateur 40 est dans l'état ouvert, suivant l'équation (1), et lorsque le commutateur 40 est dans l'état fermé, suivant l'équation (2) :

$$If_0 = \frac{Vtp_0}{Zf} = -\frac{Vtn_0}{Za + Zb} = -\frac{Vtn_0}{Zt} \qquad (1)$$

où $If_0$ est le courant de fuite lorsque le commutateur 40 est dans l'état ouvert ;

$$If_1 = \frac{Vpt_1}{\dfrac{1}{Zf} + \dfrac{1}{Zc}} = -\frac{Vnt_1}{Zt} \qquad (2)$$

où $If_1$ est le courant de fuite lorsque le commutateur 40 est dans l'état fermé.

Puis, à partir des équations (1) et (2), l'organe de calcul 46 résout le système de deux équations à deux inconnues (3) suivant:

$$\begin{cases} Zf = Zc * \left[ \dfrac{Vpt_0 * Vnt_1}{Vnt_0 * Vpt_1} - 1 \right] \\[3mm] Zt = -Zf * \dfrac{Vnt_0}{Vpt_0} = -Zc * \left[ \dfrac{Vnt_1}{Vpt_1} - \dfrac{Vnt_0}{Vpt_0} \right] \end{cases} \qquad (3)$$

Lorsque la valeur $Zt$ de l'impédance calculée est supérieure à une valeur seuil $Zt_{seuil}$, par exemple 100 ohms, l'organe de coupure 48 est commandé vers sa position ouverte, lors de l'étape 126, c'est-à-dire que les interrupteurs 50, 52 sont positionnés dans la position ouverte, de façon à couper l'alimentation de l'installation électrique 12, et éviter ainsi tout risque d'électrocution. En variante, l'installation électrique 12 reste alimentée par le système d'alimentation 10, mais une alarme est émise. En effet, lorsque la valeur $Zt$ de l'impédance de la liaison de terre 22 est supérieure à cette valeur seuil $Zt_{seuil}$, cela signifie que la carcasse de l'appareil électrique 12 présente un défaut de raccordement à la terre, et est alors susceptible d'être à un potentiel électrique dangereux pour un utilisateur.

On conçoit ainsi que le dispositif d'estimation 36 selon l'invention permet non seulement d'estimer l'impédance de la liaison de terre 22, mais aussi d'ouvrir la connexion entre l'installation électrique 12 et le système d'alimentation 10 lorsque la valeur de l'impédance de la liaison de terre 22 mesurée dépasse une valeur seuil $Zt_{seuil}$. Le dispositif d'estimation 36 permet ainsi d'éviter tout risque d'électrocution lié à un mauvais raccordement de la carcasse de l'installation électrique 12 à la terre.

En outre, l'utilisation du composant électrique 38 présentant une impédance de valeur connue $Zc$ permet au dispositif d'estimation 36 selon l'invention d'effectuer des mesures d'impédance de la liaison de terre 22 sur plusieurs installations électriques d'un même réseau électrique.

En effet, le dispositif d'estimation 36 selon l'invention, contrairement aux dispositifs d'estimation à injection de tension ou de courant de l'état de la technique, n'entraîne pas de courants de fuite additionnels, et autorise donc des mesures précises de l'impédance de la liaison de terre 22 lorsqu'il est raccordé à plusieurs installations électriques d'un même réseau.

Un tel dispositif et un tel procédé permettent également, contrairement aux dispositifs d'estimation à injection de tension ou de courant de l'état de la technique, d'estimer l'impédance de la liaison de terre 22 lorsque l'installation électrique est reliée au réseau électrique suivant le régime IT.

Le dispositif d'estimation 36 selon l'invention est utilisable non seulement sur des bornes de charge de véhicules électriques, mais aussi dans les bâtiments afin de vérifier le bon raccordement de masses électriques à la terre.

## Revendications

1. Dispositif (36) d'estimation de l'impédance (Zt) d'une liaison électrique de terre (22), la liaison de terre (22) étant reliée à la terre d'un réseau électrique alternatif (14), le réseau électrique alternatif (14) comprenant une phase reliée à un conducteur électrique de phase (18) et un neutre relié à un conducteur électrique de neutre (20), le dispositif (36) étant destiné à être raccordé au conducteur de phase (18), au conducteur de neutre (20) et à la liaison de terre (22), le dispositif (36) comprenant :

   - un composant électrique (38) présentant une impédance de valeur prédéterminée (Zc), le composant électrique (38) étant disposé entre le conducteur de phase (18) et la liaison de terre (22) ;
   - un commutateur (40) propre à isoler électriquement le composant électrique (38) du conducteur de phase (18) dans un état ouvert, et à relier électriquement le composant électrique (38) au conducteur de phase (18) dans un état fermé ;
   - un premier capteur (42) propre à mesurer une première valeur ($Vpt_0$) d'une première grandeur électrique (Vpt) entre le conducteur de phase (18) et la liaison de terre (22) lorsque le commutateur (40) est dans l'état ouvert, et
   - un deuxième capteur (44) propre à mesurer une première valeur ($Vnt_0$) d'une deuxième grandeur électrique (Vnt) entre le conducteur de neutre (20) et la liaison de terre (22) lorsque le commutateur (40) est dans l'état ouvert,

   le dispositif (36) étant **caractérisé en ce que** le premier capteur (42) est propre à mesurer une deuxième valeur ($Vpt_1$) de la première grandeur électrique (Vpt) lorsque le commutateur (40) est dans l'état fermé, le deuxième capteur (44) étant propre à mesurer une deuxième valeur ($Vnt_1$) de la deuxième grandeur électrique (Vnt) lorsque le commutateur (40) est dans l'état fermé,
   et **en ce qu'**il comprend un organe de calcul (46) propre à calculer l'impédance (Zt) de la liaison de terre (22) à partir de la valeur prédéterminée (Zc) de l'impédance du composant électrique (38) et des premières et deuxièmes valeurs ($Vpt_0$, $Vpt_1$, $Vnt_0$, $Vnt_1$) des première et deuxième grandeurs électriques (Vpt, Vnt) mesurées.

2. Dispositif (36) selon la revendication 1, **caractérisé en ce que** les première et deuxième grandeurs électriques (Vpt, Vnt) sont des tensions électriques.

3. Dispositif (36) selon la revendication 1 ou 2, **caractérisé en ce qu'**il comprend des moyens de détection (42, 44, 46, 56) du conducteur de phase (18) parmi le conducteur de phase (18) et le conducteur de neutre (20).

4. Dispositif (36) selon la revendication 3, **caractérisé en ce que** les moyens de détection (42, 44, 46, 56) comprennent :

   - un relais (56) propre à relier électriquement le conducteur de phase (18) au composant électrique (38) dans une première position, et à relier électriquement le conducteur de neutre (20) au composant électrique (38) dans une deuxième position ;
   - des moyens de mesure (42, 44) propres à mesurer la tension électrique entre le conducteur de phase (18) et la liaison de terre (22) et à mesurer la tension électrique entre le conducteur de neutre (20) et la liaison de terre (22).

5. Système (10) d'alimentation électrique d'une installation électrique (12), le système (10) étant relié à un réseau électrique alternatif (14), le réseau alternatif (14) comprenant une phase reliée à un conducteur électrique de phase (18), un neutre relié à un conducteur électrique de neutre (20) et une terre reliée à une liaison électrique de terre (22), le système (10) étant **caractérisé en ce qu'**il comprend un dispositif (36) d'estimation de l'impédance (Zt) de la liaison de terre (22) selon l'une quelconque des revendications précédentes.

6. Système (10) selon la revendication 5, **caractérisé en ce qu'**il comprend un organe de coupure (48) connecté au conducteur de phase (18) et au conducteur de neutre (20) entre le dispositif d'estimation (36) et l'installation électrique (12), l'organe de coupure (48) étant mobile entre une position ouverte dans laquelle l'installation électrique (12) est isolée du réseau électrique (14) et une position fermée dans laquelle l'installation électrique (12) est reliée au réseau électrique (14) par l'intermédiaire des conducteurs de phase (18) et de neutre (20), et **en ce que** l'organe de coupure (48) est propre à être commandé en position ouverte lorsque l'impédance (Zt) de la liaison de terre (22) calculée est supérieure à une valeur seuil ($Zt_{seuil}$).

7. Système (10) selon la revendication 6, **caractérisé en ce que** la valeur seuil ($Zt_{seuil}$) de l'impédance (Zt) de la liaison de terre (22) est comprise entre 10 ohms et 500 ohms, et en particulier sensiblement égale à 100 ohms.

8. Procédé (100) d'estimation de l'impédance (Zt) d'une liaison électrique de terre (22), la liaison électrique de terre (22) étant reliée à la terre d'un réseau électrique alternatif (14) comprenant une phase reliée à un conducteur électrique de phase (18) et un neutre relié à un conducteur électrique de neutre (20), le conducteur de phase (18), le conducteur de neutre (20) et la liaison de terre (22) étant raccordés à un dispositif (36) d'estimation de l'impédance (Zt) de la liaison de terre (22), le dispositif d'estimation (36) étant conforme à l'une quelconque des revendications 1 à 4, le procédé (100) comprenant les étapes suivantes :

   - le positionnement (116) du commutateur (40) dans l'état ouvert ; et
   - la mesure (118) de la première valeur ($Vpt_0$) de la première grandeur électrique (Vpt) par le premier capteur (42) et la mesure de la première valeur ($Vnt_0$) de la deuxième grandeur électrique (Vnt) par le deuxième capteur (44), lorsque le commutateur (40) est dans l'état ouvert ;

   le procédé étant **caractérisé en ce qu'**il comprend les étapes suivantes :

   - le positionnement (120) du commutateur (40) dans l'état fermé ;
   - la mesure (122) de la deuxième valeur ($Vpt_1$) de la première grandeur électrique (Vpt) par le premier capteur (42) et la mesure de la deuxième valeur ($Vnt_1$) de la deuxième grandeur électrique (Vnt) par le deuxième capteur (44), lorsque le commutateur (40) est dans l'état fermé ;
   - le calcul (124) de l'impédance (Zt) de la liaison de terre (22) à partir de la valeur prédéterminée (Zc) de l'impédance du composant électrique (38) et des valeurs ($Vpt_0$, $Vpt_1$, $Vnt_0$, $Vnt_1$) des première et deuxième grandeurs électriques (Vpt, Vnt) mesurées.

9. Procédé (100) selon la revendication 8, **caractérisé en ce qu'**il comprend une étape de commande (126) de l'ouverture du conducteur de phase (18) et du conducteur de neutre (20) lorsque l'impédance (Zt) de la liaison de terre (22) calculée est supérieure à une valeur seuil ($Zt_{seuil}$), l'étape de commande (126) étant réalisée au moyen d'un organe de coupure (48) connecté au conducteur de phase (18) et au conducteur de neutre (20) entre le dispositif d'estimation (36) et une installation électrique (12), l'organe de coupure (48) étant mobile entre une position ouverte dans laquelle l'installation électrique (12) est isolée du réseau électrique (14) et une position fermée dans laquelle l'installation électrique (12) est reliée au réseau électrique (14) par l'intermédiaire des conducteurs de phase (18) et de neutre (20), l'organe de coupure (48) étant commandé en position ouverte lorsque l'impédance (Zt) de la liaison de terre (22) calculée est supérieure à la valeur seuil ($Zt_{seuil}$).

10. Procédé (100) selon la revendication 8 ou 9, **caractérisé en ce qu'**il comprend une étape de détection (112) du conducteur de phase (18) parmi le conducteur de phase (18) et le conducteur de neutre (20) et une étape (114) de raccordement électrique du composant électrique (38) au conducteur de phase (18).

**Patentansprüche**

1. Vorrichtung (36) zum Schätzen der Impedanz (Zt) einer elektrischen Erdverbindung (22), wobei die Erdverbindung (22) mit der Erde eines Wechselstromnetzes (14) verbunden ist und das Wechselstromnetz (14) eine Phase, die an einen elektrischen Phasenleiter (18) angeschlossen ist, und eine Nullung, die an einen elektrischen Neutralleiter (20) angeschlossen ist, umfasst, wobei die Vorrichtung (36) vorgesehen ist, an den Phasenleiter (18), den Neutralleiter (20) und die Erdverbindung (22) angeschlossen zu werden, wobei die Vorrichtung (36) umfasst:

   - eine elektrische Komponente (38), die eine Impedanz mit vorgegebenem Wert (Zc) aufweist, wobei die elektrische Komponente (38) zwischen dem Phasenleiter (18) und der Erdverbindung (22) angeordnet ist;
   - einen Schalter (40), der geeignet ist, die elektrische Komponente (38) elektrisch vom Phasenleiter (18) in einen offenen Zustand zu trennen und die elektrische Komponente (38) in einen geschlossenen Zustand elektrisch mit dem Phasenleiter (18) zu verbinden;
- einen ersten Sensor (42), der geeignet ist, einen ersten Wert ($Vpt_0$) einer ersten elektrischen Größe (Vpt) zwischen dem Phasenleiter (18) und der Erdverbindung (22) zu messen, wenn der Schalter (40) in dem offenen Zustand ist, und
- einen zweiten Sensor (44), der geeignet ist, einen ersten Wert ($Vnt_0$) einer zweiten elektrischen Größe (Vnt) zwischen dem Neutralleiter (20) und der Erdverbindung (22) zu messen, wenn der Schalter (40) in dem offenen Zustand ist,

wobei die Vorrichtung (36) **dadurch gekennzeichnet ist, dass** der erste Sensor (42) geeignet ist, einen zweiten Wert ($Vpt_1$) der ersten elektrischen Größe (Vpt) zu messen, wenn der Schalter (40) in dem geschlossenen Zustand ist, der zweite Sensor (44) geeignet ist, einen zweiten Wert ($Vnt_1$) der zweiten elektrischen Größe (Vnt) zu messen, wenn der Schalter (40) in dem geschlossenen Zustand ist, und dass sie ein Rechenelement (46) umfasst, das geeignet ist, die Impedanz (Zt) der Erdverbindung (22) aus dem vorbestimmten Wert (Zc) der Impedanz der elektrischen Komponente (38) und den ersten und zweiten Werten ($Vpt_0$, $Vpt_1$, $Vnt_0$, $Vnt_1$) der gemessenen ersten und zweiten elektrischen Größe (Vpt, Vnt) zu berechnen.

2. Vorrichtung (36) nach Anspruch 1, **dadurch gekennzeichnet, dass** die erste und die zweite elektrische Größe (Vpt, Vnt) elektrische Spannungen sind.

3. Vorrichtung (36) nach Anspruch 1 oder 2, **dadurch gekennzeichnet, dass** sie Mittel (42, 44, 46, 56) zum Detektieren des Phasenleiters (18) aus Phasenleiter (18) und Neutralleiter (20) umfasst.

4. Vorrichtung (36) nach Anspruch 3, **dadurch gekennzeichnet, dass** die Detektionsmittel (42, 44, 46, 56) umfassen:

- ein Relais (56), das geeignet ist, elektrisch den Phasenleiter (18) mit der elektrischen Komponente (38) in einer ersten Position zu verbinden und elektrisch den Neutralleiter (20) mit der elektrischen Komponente (38) in einer zweiten Position zu verbinden;
- Messmittel (42, 44), die geeignet ist, die elektrische Spannung zwischen dem Phasenleiter (18) und der Erdverbindung (22) zu messen und die elektrische Spannung zwischen dem Neutralleiter (20) und der Erdverbindung (22) zu messen.

5. System (10) zur elektrischen Versorgung einer elektrischen Anlage (12), wobei das System (10) mit einem Wechselstromnetz (14) verbunden ist, wobei das Wechselstromnetz (14) eine Phase, die an einen elektrischen Phasenleiter (18) angeschlossen ist, eine Nullung, die an einen elektrischen Neutralleiter (20) angeschlossen ist, und eine Erde, die an eine elektrische Erdverbindung (22) angeschlossen ist, umfasst, wobei das System (10) **dadurch gekennzeichnet ist, dass** es eine Vorrichtung (36) zum Schätzen der Impedanz (Zt) der Erdverbindung (22) nach einem beliebigen der vorhergehenden Ansprüche umfasst.

6. System (10) nach Anspruch 5, **dadurch gekennzeichnet, dass** es ein Trennelement (48) umfasst, das mit dem Phasenleiter (18) und dem Neutralleiter (20) zwischen der Vorrichtung (36) zum Schätzen und der elektrischen Anlage (12) verbunden ist, wobei das Trennelement (48) zwischen einer Offenstellung, in der die elektrische Anlage (12) von dem Stromnetz (14) getrennt ist, und einer Schließstellung, in der die elektrische Anlage (12) mit dem Stromnetz (14) über den Phasenleiter (18) und den Neutralleiter (20) verbunden ist, beweglich ist, und dass das Trennelement (48) geeignet ist, in die Offenstellung gesteuert zu werden, wenn die berechnete Impedanz (Zt) der Erdverbindung (22) größer ist als ein Schwellenwert ($Zt_{seuil}$).

7. System (10) nach Anspruch 6, **dadurch gekennzeichnet, dass** der Schwellenwert ($Zt_{seuil}$) der Impedanz (Zt) der Erdverbindung (22) zwischen 10 Ohm und 500 Ohm liegt und insbesondere im Wesentlichen gleich 100 Ohm ist.

8. Verfahren (100) zum Schätzen der Impedanz (Zt) einer elektrischen Erdverbindung (22), wobei die Erdverbindung (22) mit der Erde eines Wechselstromnetzes (14) verbunden ist, das eine Phase, die an einen elektrischen Phasenleiter (18) angeschlossen ist, und eine Nullung, die an einen elektrischen Neutralleiter (20) angeschlossen ist, umfasst, wobei der Phasenleiter (18), der Neutralleiter (20) und die Erdverbindung (22) an eine Vorrichtung (36) zum Schätzen der Impedanz (Zt) einer elektrischen Erdverbindung (22) angeschlossen ist, wobei die Schätzvorrichtung (36) nach einem beliebigen der Ansprüche 1 bis 4 ausgebildet ist, wobei das Verfahren (100) die folgenden Schritte umfasst:

- Positionieren (116) des Schalters (40) in den offenen Zustand; und

- Messen (118) des ersten Wertes ($Vpt_0$) der ersten elektrischen Größe (Vpt) mit dem ersten Sensor (42) und Messen des ersten Werts ($Vnt_0$) der zweiten elektrischen Größe (Vnt) mit dem zweiten Sensor (44), wenn der Schalter (40) in dem offenen Zustand ist;

wobei das Verfahren **dadurch gekennzeichnet ist, dass** es die folgenden Schritte umfasst:

- Positionieren (120) des Schalters (40) in den geschlossenen Zustand;
- Messen (122) des zweiten Wertes ($Vpt_1$) der ersten elektrischen Größe (Vpt) mit dem ersten Sensor (42) und Messen des zweiten Werts ($Vnt_1$) der zweiten elektrischen Größe (Vnt) mit dem zweiten Sensor (44), wenn der Schalter (40) in dem geschlossenen Zustand ist;
- Berechnen (124) der Impedanz (Zt) der Erdverbindung (22) aus dem vorbestimmten Wert (Zc) der Impedanz der elektrischen Komponente (38) und den Werten ($Vpt_0$, $Vpt_1$, $Vnt_0$, $Vnt_1$) der ersten und zweiten gemessenen elektrischen Größe (Vpt, Vnt).

9. Verfahren (100) nach Anspruch 8, **dadurch gekennzeichnet, dass** es einen Schritt (126) zum Steuern des Öffnens des Phasenleiters (18) und des Neutralleiters (20), wenn die berechnete Impedanz (Zt) der Erdverbindung (22) größer als ein Schwellenwert ($Zt_{seuil}$) ist, umfasst, wobei der Steuerschritt (126) mittels eines Trennelements (48) durchgeführt wird, das zwischen der Schätzvorrichtung (36) und einer elektrischen Anlage (12) mit dem Phasenleiter (18) und dem Neutralleiter (20) verbunden ist, wobei das Trennelement (48) zwischen einer Offenstellung, in der die elektrische Anlage (12) von dem Stromnetz (14) getrennt ist, und einer Schließstellung, in der die elektrische Anlage (12) mit dem Stromnetz (14) über den Phasenleiter (18) und den Neutralleiter (20) verbunden ist, beweglich ist, wobei das Trennelement (48) in die Offenstellung gesteuert wird, wenn die berechnete Impedanz (Zt) der Erdverbindung (22) größer als der Schwellenwert ($Zt_{seuil}$) ist.

10. Verfahren (100) nach Anspruch 8 oder 9, **dadurch gekennzeichnet, dass** es einen Schritt (112) des Detektierens des Phasenleiters (18) aus Phasenleiter (18) und Neutralleiter (20) und einen Schritt (114) des elektrischen Verbindens der elektrischen Komponente (38) mit dem Phasenleiter (18) umfasst.

## Claims

1. A device (36) for estimating the impedance (Zt) of an electric ground connection (22), the ground connection (22) being connected to the ground of an alternating electric network (14), the alternating electric network (14) comprising a phase connected to an electric phase conductor (18) and a neutral connected to an electric neutral conductor (20), the device (36) being intended to be connected to the phase conductor (18), the neutral conductor (20) and the ground connection (22), the device (36) comprising:

- an electrical component (38) having an impedance with a predetermined value (Zc), the electrical component (38) being positioned between the phase conductor (18) and the ground connection (22);
- a switch (40) capable of electrically isolating the electrical component (38) of the phase conductor (18) in an open state, and electrically connecting the electrical component (38) to the phase conductor (18) in a closed state;
- a first sensor (42) capable of measuring a first value ($Vpt_0$) of a first electrical property (Vpt) between the phase conductor (18) and the ground connection (22) when the switch (40) is in the open state, and
- a second sensor (44) capable of measuring a first value ($Vnt_0$) of a second electrical property (Vnt) between the neutral conductor (20) and the ground connection (22) when the switch (40) is in the open state,

the device (36) being **characterized in that** the first sensor (42) is capable of measuring a second value ($Vpt_1$) of the first electrical property (Vpt) when the switch (40) is in the closed state, the second sensor (44) being capable of measuring a second value ($Vnt_1$) of the second electrical property (Vnt) when the switch (40) is in the closed state, and **in that** it comprises a computation member (46) capable of computing the impedance (Zt) of the ground connection (22) from the predetermined value (Zc) of the impedance of the electrical component (38) and values ($Vpt_0$, $Vpt_1$, $Vnt_0$, $Vnt_1$) of the first and second measured electrical properties (Vpt, Vnt).

2. The device (36) according to claim 1, **characterized in that** the first and second electrical properties (Vpt, Vnt) are electrical voltages.

3. The device (36) according to claim 1 or 2, **characterized in that** it comprises means (42, 44, 46, 56) for detecting the phase conductor (18) from among the phase conductor (18) and neutral conductor (20).

**4.** The device (36) according to claim 3, **characterized in that** the detection means (42, 44, 46, 56) comprise:

- a relay (56) capable of electrically connecting the phase conductor (18) to the electrical component (38) in a first position, and electrically connecting the neutral conductor (20) to the electrical component (38) in a second position; and
- measuring means (42, 44) capable of measuring the electrical voltage between the phase conductor (18) and the ground connection (22), and measuring the electrical voltage between the neutral conductor (20) and the ground connection (22).

**5.** An electric power supply system (10) for an electrical installation (12), the system (10) being connected to an alternating electrical grid (14), the alternating grid (14) comprising a phase connected to an electric phase conductor (18), a neutral connected to an electric neutral conductor (20), and a ground connected to an electric ground connection (22), the system (10) being **characterized in that** it comprises a device (36) for estimating the impedance (Zt) of the ground connection (22) according to any one of the preceding claims.

**6.** The system (10) according to claim 5, **characterized in that** it comprises a cutoff member (48) connected to the phase conductor (18) and to the neutral conductor (20) between the estimating device (36) and the electrical installation (12), the cutoff member (48) being movable between an open position, in which the electrical installation (12) is isolated from the electrical grid (14), and a closed position, in which the electrical installation (12) is connected to the electrical grid (14) by means of phase (18) and neutral (20) conductors, and **in that** the cutoff member (48) is capable of being commanded in the open position when the computed impedance (Zt) of the ground connection (22) is above a threshold value ($Z_{seuil}$).

**7.** The system (10) according to claim 6, **characterized in that** the threshold value ($Zt_{seuil}$) of the impedance (Zt) of the ground connection (22) is comprised between 10 ohms and 500 ohms, and in particular substantially equal to 100 ohms.

**8.** A method (100) for estimating the impedance (Zt) of an electric ground connection (22), the electric ground connection (22) being connected to the ground of an alternating electrical grid (14) comprising a phase connected to an electric phase conductor (18) and a neutral connected to an electric neutral conductor (20), the phase conductor (18), the neutral conductor (20) and the ground connection (22) being connected to a device (36) for estimating the impedance (Zt) of the ground connection (22), the estimating device (36) being according to any one of claims 1 to 4, the method (100) comprising the following steps:

- positioning (116) the switch (40) in the open state; and
- measuring (118) the first value ($Vpt_0$) of the first electrical property (Vpt) using the first sensor (42) and measuring the first value ($Vnt_0$) of the second electrical property (Vnt) using the second sensor (44), when the switch (40) is in the open state;

the method being **characterized in that** it comprises the following steps:

- positioning (120) the switch (40) in the closed state;
- measuring (122) the second value ($Vpt_1$) of the first electrical property (Vpt) using the first sensor (42) and measuring the second value ($Vnt_1$) of the second electrical property (Vnt) using the second sensor (44), when the switch (40) is in the closed state; and
- computing (124) the impedance (Zt) of the ground connection (22) from the predetermined value (Zc) of the impedance of the electrical component (38) and the values ($Vpt_0$, $Vpt_1$, $Vnt_0$, $Vnt_1$) of the first and second measured electrical properties (Vpt, Vnt).

**9.** The method (100) according to claim 8, **characterized in that** it comprises a step (126) for commanding the opening of the phase conductor (18) and the neutral conductor (20) when the computed impedance (Zt) of the ground connection (22) is above a threshold value ($Zt_{seuil}$), the command step (126) being carried out using a cutoff member (48) connected to the phase conductor (18) and to the neutral conductor (20) between the estimating device (36) and the electrical installation (12), the cutoff member (48) being movable between an open position, in which the electrical installation (12) is isolated from the electrical grid (14), and an open position, in which the electrical installation (12) is connected to the electrical grid (14) by means of phase (18) and neutral (20) conductors, the cutoff member (48) being commanded in the open position when the computed impedance (Zt) of the ground connection (22) is above the threshold value ($Zt_{seuil}$).

**10.** The method (100) according to claim 8 or 9, **characterized in that** it comprises a step (112) for detecting the phase conductor (18) from among the phase conductor (18) and the neutral conductor (20), and a step (114) for electrically connecting the electrical component (38) to the phase conductor (18).

FIG.1

FIG.2

FIG.3

100 {

Raccordement du dispositif d'estimation au système d'alimentation — 110

↓

Détection du conducteur de phase — 112

↓

Connexion du relais au conducteur de phase — 114

↓

Ouverture du commutateur — 116

↓

Mesure des tensions $Vpt_0$ et $Vnt_0$ — 118

↓

Fermeture du commutateur — 120

↓

Mesure des tensions $Vpt_1$ et $Vnt_1$ — 122

↓

Calcul de l'impédance Zt de la liaison de terre — 124

↓

Si Zt > Zt seuil, ouverture de l'organe de coupure — 126

## FIG.4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2551981 A1